# EUROPEAN PATENT APPLICATION

(11) **EP 4 734 684 A1**
(43) Date of publication of application: **29.04.2026**
(21) Application number: 25201471.7
(22) Date of filing: 10.09.2025
(51) Int. Cl.: H05K 7/20

(54) **DISPLAY DEVICE AND ELECTRONIC DEVICE INCLUDING THE SAME**

(30) Priority: 25.10.2024 KR 20240147532
(71) Applicant: Samsung Display Co., Ltd., Yongin-si, Gyeonggi-Do (KR)
(72) Inventor: KIM, Wan-Sang, Yongin-si (KR); PARK, Byoungkyoo, Yongin-si (KR); JEONG, Wee-Joon, Yongin-si (KR); CHOI, Jang Un, Yongin-si (KR)
(74) Representative: Marks & Clerk LLP

(57) **Abstract**

A display device includes a display panel (DP) including opposing first and second surfaces (S1, S2), and a heat dissipation member (100) including a first heat dissipation layer (110) disposed on the second surface (S2) of the display panel (DP) and a second heat dissipation layer (120) disposed on the first heat dissipation layer (110).

## Description

### BACKGROUND

The disclosure relates to a display device including a display panel.

Examples of display devices include a liquid crystal display ("LCD"), a plasma display panel ("PDP"), an organic light-emitting diode device ("OLED"), a field effect display ("FED"), and an electrophoretic display device.

A light-emitting display device includes two electrodes and a light-emitting layer disposed therebetween, where electrons injected from one electrode and holes injected from the other electrode combine in the light-emitting layer to form excitons, and the excitons emit light while emitting energy.

The temperature inside the light-emitting display device increases due to the heat generated during operation. As the internal temperature of the display device increases, heat-sensitive light-emitting layers may deteriorate. As the light-emitting layer or the like deteriorates, the lifespan of the light-emitting display device may be shortened and the display quality may deteriorate.

### SUMMARY

The embodiments attempt to provide a display device having an improved heat dissipation effect even when there is a plurality of heating regions.

The invention provides a display device comprising, a display panel including a first surface and a second surface opposing each other, and a heat dissipation member including a first heat dissipation layer disposed on the second surface of the display panel and a second heat dissipation layer disposed on the first heat dissipation layer.

The first heat dissipation layer may include a plurality of first heat dissipation sheets arranged in a first direction or a second direction intersecting the first direction. The second heat dissipation layer may include a plurality of second heat dissipation sheets arranged in a first direction or a second direction intersecting the first direction.

The first heat dissipation sheets next to each other among the plurality of first heat dissipation sheets may be partitioned by a first boundary line extending in the second direction, and a second heat dissipation sheet of the plurality of second heat dissipation sheets may cover the first boundary line.

An edge of a first heat dissipation sheet extending in the first direction among the plurality of first heat dissipation sheets may be aligned with an edge of the second heat dissipation sheet extending in the first direction.

The first heat dissipation layer may include a plurality of first heat dissipation sheets partitioned by a second boundary line extending in the first direction, and the second heat dissipation layer may include the second heat dissipation sheet covering the second boundary line.

The first heat dissipation layer may include a plurality of first heat dissipation sheets partitioned into a first boundary line extending in the second direction and a second boundary line extending in the first direction, and the second heat dissipation sheet may not cover the first boundary line or the second boundary line.

The at least one edge of the first heat dissipation sheet may be misaligned with at least one edge of the second heat dissipation sheet.

The distance between the first heat dissipation sheets next (adjacent) to each other among the plurality of first heat dissipation sheets may be 3 mm or less, and the distance between second heat dissipation sheets next (adjacent) to each other among the plurality of second heat dissipation sheets may be 3 mm or less.

The first heat dissipation sheet and the second heat dissipation sheet may include a vapor chamber.

The at least one of the first heat dissipation sheet and the second heat dissipation sheet may include a pulsating heat pipe.

The first heat dissipation sheet may include a first pipe including a first straight flow path, a first connecting flow path, and a first closed flow path, the second heat dissipation sheet may include a second pipe including a second straight flow path, a second connecting flow path, and a second closed flow path, and the first pipe and the second pipe may be closed-loop pulsating heat pipes.

The at least one of cross-sections of the first straight flow path and cross-sections of the second straight flow path may include a first region, a second region, and a third region having different diameters from each other.

The extension directions of the first straight flow path and the second straight flow path may be parallel to each other.

The first straight flow path and the second straight flow path may intersect each other.

The first straight flow path may extend in the first direction, and the second straight flow path may extend in the second direction.

The first straight flow path and the second straight flow path may extend in a diagonal direction with respect to the first direction and the second direction.

The extension directions of the first straight flow path and the second straight flow path may be parallel to each other.

The extension directions of the first straight flow path and the second straight flow path may intersect each other.

The display panel may include a substrate, a transistor disposed on the substrate, a pixel electrode electrically connected to the transistor, a light-emitting layer disposed on the pixel electrode, and a common electrode disposed on the light-emitting layer.

A display device in an embodiment includes a display panel including a first surface from which light for displaying an image may be emitted and a second surface opposite to the first surface, and a heat dissipation member including a first heat dissipation layer disposed on the second surface and a second heat dissipation layer disposed on the first heat dissipation layer.

The first heat dissipation layer may include at least one first heat dissipation sheet arranged in a first direction or a second direction intersecting the first direction, and the second heat dissipation layer may include at least one second heat dissipation sheet arranged in the first direction or the second direction.

An electronic device in an embodiment includes a heat source including one surface, and a heat dissipation member including a first heat dissipation layer disposed on the one surface of the heat source and a second heat dissipation layer disposed on the first heat dissipation layer.

Each of the first heat dissipation layer and the second heat dissipation layer may include a first heat dissipation sheet and a second heat dissipation sheet, and at least one of the first heat dissipation layer and the second heat dissipation layer may include a plurality of first heat dissipation sheets or a plurality of second heat dissipation sheets.

The heat source may include a display device.

By embodiments, the rate of diffusion of heat generated in the display panel may be improved. Accordingly, local temperature increase of the display panel may be prevented, thereby preventing damage caused by heat from a heat source of the display panel. Therefore, the display quality of the display device may be improved, and the lifespan characteristics of the display device may be improved.

By embodiments, it is possible to diffuse heat even when using relatively large display panels. Accordingly, it is possible to effectively diffuse heat even in relatively large display panels, and suppress local temperature increases. Additionally, the process cost for arranging devices for heat dissipation may be reduced even in relatively large display panels.

At least some of the above and other features of the invention are set out in the claims.

### BRIEF DESCRIPTION OF THE DRAWINGS

The above and other embodiments, advantages and features of this disclosure will become more apparent by describing in further detail embodiments thereof with reference to the accompanying drawings.
FIG. 1 is a schematic top plan view of an embodiment of a display device.
FIG. 2 is a schematic cross-sectional view illustrating an embodiment of a display area of a display device.
FIG. 3 is a schematic side view of an embodiment of a display device.
FIG. 4 is a schematic side view of an embodiment of a heat dissipation member applied to a display device.
FIG. 5 is an enlarged view of region A of FIG. 4.
FIG. 6 is a graph showing the heat diffusion effect according to the distance between neighboring (adjacent) heat dissipation sheets of a heat dissipation member according to FIG. 5.
FIG. 7 is a schematic perspective view of an embodiment of a heat dissipation member applied to a display device.
FIG. 8 is a schematic top plan view of the heat dissipation member shown in FIG. 7.
FIG. 9 is a schematic perspective view of an embodiment of a heat dissipation member applied to a display device.
FIG. 10 is a schematic top plan view of the heat dissipation member shown in FIG. 7.
FIG. 11 is a schematic perspective view of an embodiment of a heat dissipation member applied to a display device.
FIG. 12 is a schematic top plan view of the heat dissipation member shown in FIG. 11.
FIG. 13 is a graph showing the temperature change according to the distance from a heat source when a vapor chamber is used.
FIGS. 14 to 21 are schematic exploded perspective views of an embodiment of heat dissipation members applied to display devices.
FIG. 22 is a schematic top plan view of an embodiment of a heat dissipation sheet applied to a display device.
FIGS. 23 to 25 are schematic side views of an embodiment of display devices.
FIG. 26 is a block diagram of an embodiment of an electronic device in some embodiments.
FIG. 27 is a schematic diagram of an embodiment of electronic devices in some embodiments.

### DETAILED DESCRIPTION

The disclosure will be described in detail hereinafter with reference to the accompanying drawings, in which embodiments of the disclosure are shown. As those skilled in the art would realize, the described embodiments may be modified in various different ways, all without departing from the scope of the disclosure.

The drawings and description are to be regarded as illustrative in nature and not restrictive, and like reference numerals designate like elements throughout the specification.

Further, since sizes and thicknesses of components shown in the accompanying drawings may be arbitrarily given to facilitate understanding and ease of description, the disclosure is not limited to the illustrated sizes and thicknesses. In the drawings, the thicknesses of layers, films, panels, regions, etc., are exaggerated for clarity. In the drawings, to facilitate understanding and ease of description, the thicknesses of some layers and regions may be exaggerated.

It should be understood that when an element such as a layer, film, region, or substrate is referred to as being "on" another element, it may be directly on the other element or intervening elements may also be present. In contrast, when an element is referred to as being "directly on" another element, there are no intervening elements present. Further, when an element is referred to as being "on" or "above" a reference element, it may be disposed above or below the reference element, and it may not necessarily be referred to as being disposed "on" or "above" it in a direction opposite to gravity.

In addition, unless explicitly described to the contrary, the word "comprise," and variations such as "comprises" and "comprising," should be understood to imply the inclusion of stated elements but not the exclusion of any other elements.

In addition, the phrase "in a plan view" means a view from a position above the object (e.g., from the top), and the phrase "in a cross-section" means a view of a cross-section of the object which is vertically cut from the side.

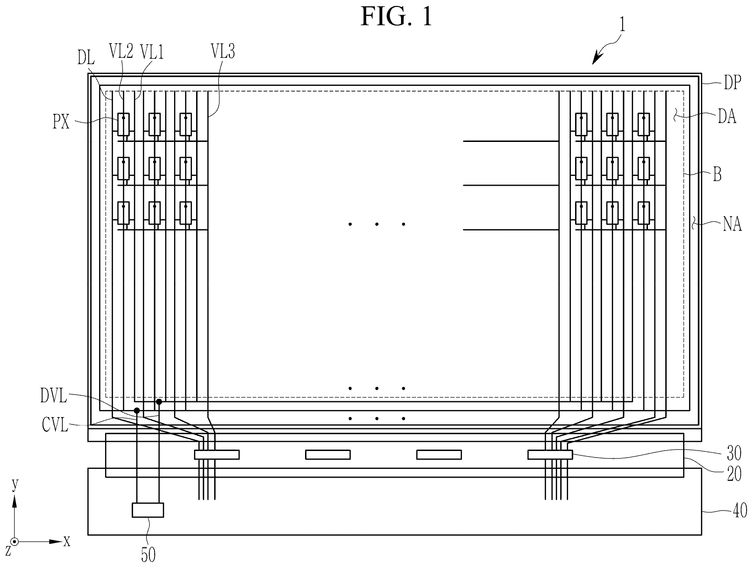

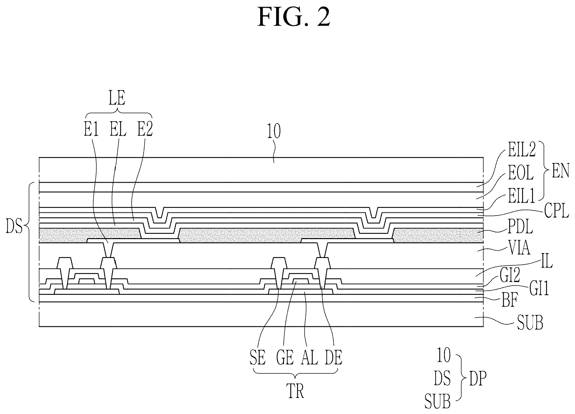

FIG. 1 is a schematic top plan view of an embodiment of a display device. FIG. 2 is a schematic cross-sectional view showing a portion of an embodiment of a display area of the display device.

Referring to FIG. 1, a display device 1 may include a display panel DP, a flexible printed circuit board 20, a driving integrated circuit chip 30, a printed circuit board 40, a power module 50, etc.

The display panel DP may include a display area DA corresponding to a screen for displaying an image, and a non-display area NA in which circuits and wirings for generating and transmitting various signals applied to the display area DA are disposed. The non-display area NA may be next (adjacent) to the display area DA or may surround the display area DA. In FIG. 1, the inner and outer areas of a boundary line B may be the display area DA and the non-display area NA, respectively.

The display area DA of the display panel DP may include pixels PX disposed in a matrix. Additionally, a data line DL for transmitting a data voltage, a driving voltage line VL1 for transmitting a driving voltage, a common voltage line VL2 for transmitting a common voltage, and an initialization voltage line VL3 for transmitting an initialization voltage may be disposed in the display area DA. The driving voltage line VL1, the common voltage line VL2, and the initialization voltage line VL3 may extend in the second direction (y). At least one of the driving voltage line VL1, the common voltage line VL2, and the initialization voltage line VL3 may be connected to an auxiliary voltage line extending in the first direction (x).

The non-display area NA of the display panel DP may include a driving voltage transmission line DVL, a common voltage transmission line CVL, etc., connected to driving voltage lines VL1. Each of the driving voltage transmission line DVL and the common voltage transmission line CVL may include portions extending in an approximately longitudinal direction (y) and portions extending in an approximately width direction (x). The common voltage transmission line CVL may be disposed to surround the display area DA.

The flexible printed circuit board 20 may have one end connected or bonded to a display unit DS (see Figure 2) of the display panel DP, and an opposite end connected or bonded to the printed circuit board 40. The flexible printed circuit board 20 may have the driving integrated circuit chip 30 disposed thereon, including a data driver.

The power module 50 for generating a power voltage such as a driving voltage, a common voltage, etc., may be disposed on the printed circuit board 40. The power module 50 may be provided in the form of an integrated circuit chip. A signal controller (not shown) that controls the data driver and a gate driver may be disposed on the printed circuit board 40.

Referring to FIG. 2, the display panel DP may include a lower substrate SUB, a display unit DS, and an upper substrate 10.

The lower substrate SUB may include a material having rigid characteristics, such as glass, or a material having flexible characteristics, such as plastic. In an embodiment, the lower substrate SUB may be a glass substrate. The lower substrate SUB may include a polymer material, for example.

The display unit DS may include a buffer layer BF, a transistor TR, insulating layers GI1, GI2, IL, and VIA, a pixel defining layer PDL, a light-emitting device LE, a capping layer CPL, and an encapsulation layer EN.

The buffer layer BF may be disposed on the lower substrate SUB. The buffer layer BF may block impurities from the lower substrate SUB when forming a semiconductor layer AL, thereby improving the characteristics of the semiconductor layer, and may also alleviate the stress on the semiconductor layer AL by planarizing the surface of the lower substrate SUB. The buffer layer BF may be an inorganic insulating layer that may include an inorganic insulating material, and may have a single-layer structure or a multi-layer structure.

A first conductive layer may be disposed on the lower substrate SUB. In an embodiment, a first conductive layer that may include a light-shielding pattern or the like may be disposed between the lower substrate SUB and the buffer layer BF. The components included in the first conductive layer may be formed from the same material in the same process. In an embodiment, a conductive layer may be deposited and patterned on the lower substrate SUB to form data lines DL, driving voltage lines VL1, common voltage lines VL2, initialization voltage lines VL3, and light-shielding patterns, for example.

The transistor TR may be disposed on the lower substrate SUB. In an embodiment, the transistor TR may be disposed on the buffer layer BF disposed on the lower substrate SUB, for example.

The semiconductor layer AL of the transistor TR may be disposed on the lower substrate SUB. The semiconductor layer AL may include a first semiconductor region, a second semiconductor region, and a channel region disposed between the first semiconductor region and the second semiconductor region. The semiconductor layer AL may include any one of amorphous silicon, polycrystalline silicon, and oxide semiconductor, for example. In an embodiment, the semiconductor layer AL may include an oxide semiconductor material, for example.

The first insulating layer GI1 may be disposed on the semiconductor layer AL. The first insulating layer GI1 may be also referred to as a first gate insulating layer. The first insulating layer GI1 may include an inorganic insulating material. The first insulating layer GI1 may have a single-layer structure or a multi-layer structure.

A gate conductive layer, which may include a gate electrode GE of the transistor TR, etc., may be disposed on the first insulating layer GI1. The gate conductive layer may include, for example, molybdenum (Mo), aluminum (Al), copper (Cu), titanium (Ti), etc., and may have a single-layer structure or a multi-layer structure.

The second insulating layer GI2 may be disposed on the gate conductive layer. The second insulating layer GI2 may be also referred to as a second gate insulating layer. The second insulating layer GI2 may include an inorganic insulating material. The second insulating layer GI2 may have a single-layer structure or a multi-layer structure.

An inter-insulating layer IL may be disposed on the second insulating layer GI2. The inter-insulating layer IL may include an inorganic insulating material such as silicon nitride, silicon oxide, or silicon oxynitride. The inter-insulating layer IL may have a single-layer structure or a multi-layer structure. An additional gate conductive layer may be disposed on the inter-insulating layer IL.

A data conductive layer, which may include a first lower electrode SE, a second lower electrode DE, etc., of the transistor TR, may be disposed on the inter-insulating layer IL. Each of the first lower electrode SE and the second lower electrode DE may be connected to the first semiconductor region and the second semiconductor region of the semiconductor layer AL, through contact holes defined in the insulating layers GI1, GI2, and IL. One of the first lower electrode SE and the second lower electrode DE may be a source electrode and a remaining (the other) one may be a drain electrode.

The data conductive layer may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), copper (Cu), or the like, and may have a single-layer structure or a multi-layer structure. In an embodiment, the data conductive layer may include a lower layer including a refractory metal, an intermediate layer including a low-resistivity metal, and an upper layer including a refractory metal.

The third insulating layer VIA may be disposed on the data conductive layer. The third insulating layer VIA may be also referred to as a planarized layer. In an embodiment, the third insulating layer VIA may be disposed on the transistor TR including the semiconductor layer AL, the gate electrode GE, the first lower electrode SE, and the second lower electrode DE, for example. The third insulating layer VIA may be disposed on the second insulating layer GI2.

The third insulating layer VIA may include an organic insulating material including a common general polymer, a polymer derivative having a phenol-based group, an acryl-based polymer, an imide-based polymer, or a siloxane-based polymer.

The light-emitting device LE may be disposed on the third insulating layer VIA. The light-emitting device LE may include a pixel electrode E1, a light-emitting layer EL, and a common electrode E2. The light-emitting device LE is disposed on a planarized layer VIA and may be electrically connected to the transistor (TR).

The light-emitting device LE may include the pixel electrode E1. The pixel electrode E1 may be disposed on the third insulating layer VIA disposed on the lower substrate SUB. The pixel electrode E1 may be provided as an anode of the light-emitting device LE. The pixel electrode E1 may be electrically connected to the transistor TR. In an embodiment, the pixel electrode E1 may be connected to the second lower electrode DE of the transistor TR through a contact hole defined in the third insulating layer VIA, for example.

The pixel electrode E1 may include or consist of a reflective conductive material or a semi-transparent conductive material, or may include or consist of a transparent conductive material. The pixel electrode E1 may include a metal or a metal alloy. The pixel electrode E1 may have a multi-layer structure.

The pixel defining layer PDL defining an opening overlapping the pixel electrode E1 may be disposed on the third insulating layer VIA. The pixel electrode E1 may be disposed in an opening in the pixel defining layer PDL. The opening may correspond to the light-emitting region of the light-emitting device LE.

The pixel defining layer PDL may include an organic insulating material.

The light-emitting layer EL may be disposed on at least one of the pixel electrode E1 and the pixel defining layer PDL. The light-emitting layer EL is a layer in which electro-optic transfer occurs through the combination of electrons and holes, and may include at least one of an organic material and an inorganic material that emits light of a predetermined color. The light-emitting layer EL may be disposed in the opening of the pixel defining layer PDL and may overlap the pixel electrode E1. A portion of the light-emitting layer EL may be disposed on the pixel defining layer PDL. The light-emitting layer EL may include an organic light-emitting diode or an inorganic light-emitting diode.

A functional layer may be disposed under or on the light-emitting layer EL. The functional layer may include at least one of a hole injection layer, a hole transport layer, an electron transport layer, and an electron injection layer. The functional layer may include a first functional layer disposed between the pixel electrode E1 and the light-emitting layer EL, and a second functional layer disposed between the light-emitting layer EL and the common electrode E2. The first functional layer may include at least one of a hole injection layer and a hole transport layer. The second functional layer may include at least one of an electron transport layer and an electron injection layer. The functional layer may be disposed across the entirety of the display area DA as described with reference to FIG. 1. The functional layer may be disposed in the opening of the pixel defining layer PDL. The functional layer may be disposed outside the opening of the pixel defining layer PDL.

The common electrode E2 may be disposed on at least one of the light-emitting layer EL and the functional layer. The pixel electrode E1 may be provided as an anode of the light-emitting device LE, and the common electrode E2 may be provided as a cathode of the light-emitting device LE. The common electrode E2 may be disposed across the entirety of the display area DA as described with reference to FIG. 1.

The common electrode E2 may include a metal or metal alloy having a relatively low work function. In an embodiment, light transparency may be achieved by forming a relatively thin layer of a metal or metal alloy having the relatively low work function, for example. The common electrode E2 may include a transparent conductive oxide.

The common electrode E2 may form the light-emitting device LE together with the pixel electrode E1 and the light-emitting layer EL. The light-emitting device LE may include the functional layer including the first functional layer and the second functional layer.

The capping layer CPL may be disposed on the common electrode E2. The capping layer CPL may improve light efficiency by adjusting the refractive index.

The encapsulation layer EN may be disposed on the capping layer CPL. The encapsulation layer EN may encapsulate a light-emitting device LE including the light-emitting layer EL to prevent moisture or oxygen from penetrating from the outside. The encapsulation layer EN may be a thin-film encapsulation layer including one or more inorganic layers EIL1 and EIL2 and one or more organic layers EOL.

The upper substrate 10 may be disposed on the display unit DS. The upper substrate 10 may include substantially the same material as that of the lower substrate SUB. The upper substrate 10 may include a material having rigid characteristics such as glass or a material having flexible characteristics such as plastic. In an embodiment, the upper substrate 10 may be a glass substrate and may also include a polymer material, for example.

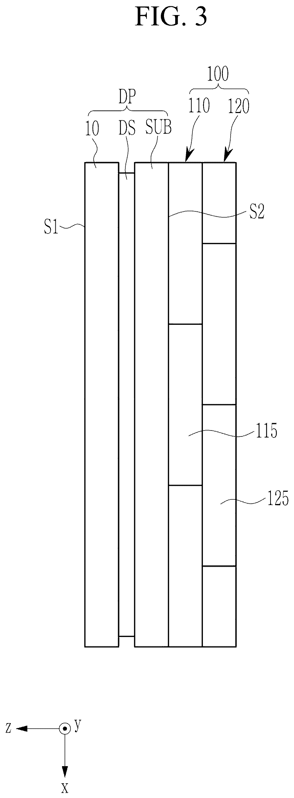

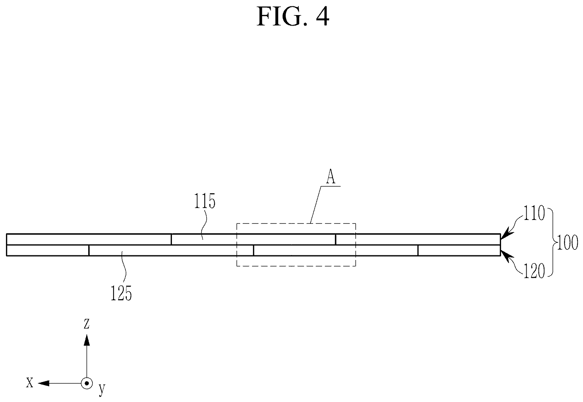

FIG. 3 is a schematic side view of an embodiment of a display device. FIG. 4 is a schematic side view of an embodiment of a heat dissipation member applied to a display device.

Referring to FIG. 3, a heat dissipation member 100 may be disposed on at least one surface of the display panel DP.

The display panel DP may include a first surface S1 and a second surface S2 opposing each other. The first surface S1 may refer to a surface from which light is emitted from the display unit DS of the display panel DP to the outside of the display panel DP. The first surface S1 may refer to a surface on which an image emitted from the display unit DS may be displayed, and thus an image may be recognized from the outside of the display panel DP. In an embodiment, the first surface S1 may refer to a surface on which the upper substrate 10 of the display panel DP is disposed, for example. The second surface S2 may refer to a surface from which light is not emitted from the display unit DS of the display panel DP to the outside of the display panel DP. The second surface S2 may refer to a surface of the display panel DP from which the image is not visible from the outside. In an embodiment, the second surface S2 may refer to a surface on which the lower substrate SUB of the display panel DP is disposed, for example. The heat dissipation member 100 may be disposed on the second surface S2 of the display panel. In an embodiment, the lower substrate SUB of the display panel DP may be disposed on the heat dissipation member 100, for example.

The heat dissipation member 100 may include a first heat dissipation layer 110 and a second heat dissipation layer 120. The first heat dissipation layer 110 may be disposed on the second surface S2 of the display panel DP. The second heat dissipation layer 120 may be disposed on the first heat dissipation layer 110. The first heat dissipation layer 110 may be disposed between the display panel DP and the second heat dissipation layer 120. In an embodiment, the first heat dissipation layer 110 may be disposed on the display panel DP, and the second heat dissipation layer 120 may be disposed on the first heat dissipation layer 110, for example.

The first heat dissipation layer 110 may include a plurality of first heat dissipation sheets 115 arranged in a first direction (e.g., x-axis direction). Since the first heat dissipation layer 110 may include a plurality of first heat dissipation sheets 115, even when a relatively large display panel DP is used as the display panel DP, the process difficulty and process cost may be reduced.

The second heat dissipation layer 120 may include a plurality of second heat dissipation sheets 125 arranged in the first direction (x). Since the second heat dissipation layer 120 may include a plurality of second heat dissipation sheets 125, even when a relatively large panel is used as the display panel DP, the process difficulty and process cost may be reduced.

In FIG. 3, the first heat dissipation layer 110 is illustrated as including a plurality of first heat dissipation sheets 115 arranged in the first direction (x), and the second heat dissipation layer 120 is illustrated as including a plurality of second heat dissipation sheets 125 arranged in the first direction (x). However, the arrangement of the first heat dissipation sheet 115 of the first heat dissipation layer 110 and the second heat dissipation sheet 125 of the second heat dissipation layer 120 is not limited thereto.

The first heat dissipation layer 110 may include a plurality of first heat dissipation sheets 115 arranged in a first direction (e.g., x-axis direction). The second heat dissipation layer 120 may include a plurality of second heat dissipation sheets 125 arranged in the second direction (y) intersecting the first direction (x).

"Second direction intersecting" may refer to a direction that is not parallel to the first direction. In an embodiment, it may refer to a case where a straight line extending in the first direction and a straight line extending in the second direction on the same plane meet at a predetermined angle, for example. The first direction and the second direction may also mean directions that are perpendicular to each other. In an embodiment, the first direction may refer to the "first direction (x)" or "approximately width direction (x)" of the display panel DP described with reference to FIG. 1, for example. The first direction may refer to the x direction in FIG. 3. In an embodiment, the second direction may refer to the "second direction (y)" or "approximately longitudinal direction (y)" of the display panel DP described with reference to FIG. 1, for example. The second direction may refer to the y direction in FIG. 3. The first direction and the second direction are not limited thereto, and may refer to directions that may be defined in a plan view parallel to the second plane. In an embodiment, the first direction may refer to the "second direction (y)" or the "approximately longitudinal direction (y)" of the display panel DP described with reference to FIG. 1, for example. The second direction may also refer to the "first direction (x)" or "approximately width direction (x)" of the display panel DP described with reference to FIG. 1. However, for convenience of explanation, in the following description, the first direction refers to the x direction and the second direction refers to the y direction.

The first heat dissipation layer 110 may include a plurality of first heat dissipation sheets 115 arranged in the second direction (y). The first heat dissipation layer 110 may include a plurality of first heat dissipation sheets 115 arranged in both the first direction (x) and the second direction (y).

The second heat dissipation layer 120 may include a plurality of second heat dissipation sheets 125 arranged in the second direction (y). The second heat dissipation layer 120 may include a plurality of heat dissipation layers arranged in both the first direction (x) and the second direction (y).

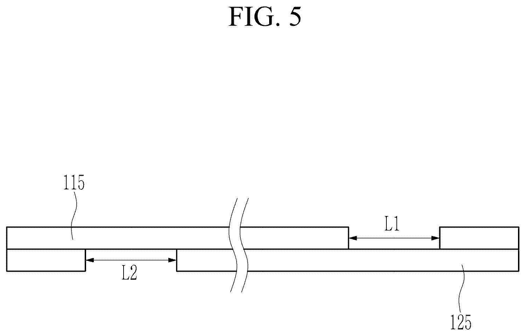

FIG. 5 is an enlarged view of region A of FIG. 4.

Referring to FIG. 5, the neighboring (adjacent) first heat dissipation sheets 115 of the first heat dissipation layer 110 may have a gap of a first distance L1. In FIG. 5, the first heat dissipation sheets 115 next (adjacent) to each other in the first direction (x) are illustrated as having a gap, but the first heat dissipation sheets 115 next (adjacent) to each other in the second direction (y) may also have a gap. There may be a gap between the neighboring (adjacent) second heat dissipation sheets 125 of the second heat dissipation layer 120. In FIG. 5, the second heat dissipation sheets 125 next (adjacent) to each other in the first direction (x) are illustrated as having a gap, but the first heat dissipation sheets 125 next (adjacent) to each other in the second direction (y) may also have a gap.

The first heat dissipation sheets 115 next (adjacent) to each other may have a gap of the first distance L1. The first distance L1 may be 3 millimeters (mm) or less, 2 mm or less, or 1 mm or less. The distance between the first dissipation sheets next (adjacent) to each other 115 may be 0 mm or more, 0.01 mm or more, or 0.05 mm or more. The distance between the first heat dissipation sheets 115 next (adjacent) to each other in the first direction (x) and the distance between the first heat dissipation sheets 115 next (adjacent) to each other in the second direction (y) may both be within the above ranges.

The second heat dissipation sheets 125 next (adjacent) to each other may have a gap of a second distance L2. The second distance L2 may be 3 mm or less, 2 mm or less, or 1 mm or less. The distance between the second dissipation sheets 125 next (adjacent) to each other may be 0 mm or more, 0.01 mm or more, or 0.05 mm or more. The distance between the second heat dissipation sheets 125 next (adjacent) to each other in the first direction (x) and the distance between the first heat dissipation sheets 115 next (adjacent) to each other in the second direction (y) may both be within the above ranges.

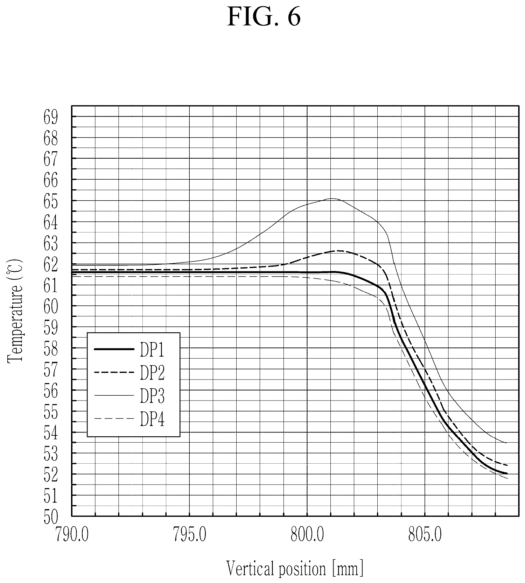

FIG. 6 shows a graph of the heat diffusion effect when the distance between heat dissipation sheets next (adjacent) to each other is 1 mm (DP1), 2.5 mm (DP2), 4.5 mm (DP3), and 0 mm (DP4). In FIG. 6, the temperature at a vertical position of 790.0 mm corresponds to the initial temperature.

In an embodiment, when the distance between heat dissipation sheets next (adjacent) to each other was 3 mm or less (DP1, DP2, and DP4), the temperature difference between the initial temperature and the maximum temperature according to the vertical position was less than 3 degrees Celsius (°C), for example.

When the distance between heat dissipation sheets next (adjacent) to each other was less than 2 mm (DP1 and DP4), the temperature difference between the initial temperature and the maximum temperature according to the vertical position was less than 1°C.

When the distance between heat dissipation sheets next (adjacent) to each other was less than 1 mm (DP4), the initial temperature according to the vertical position corresponded to the maximum temperature.

However, when the distance between heat dissipation sheets next (adjacent) to each other exceeded 3 mm (DP3), the temperature difference between the initial temperature and the maximum temperature according to the vertical position exceeded 4°C.

As seen in FIG. 6, when the neighboring (adjacent) heat dissipation sheets 115 and 125 have a gap within the range described with reference to FIG. 5, the heat diffusion efficiency is improved because the temperature does not increase excessively in a predetermined section.

Referring to FIGS. 5 and 6, when the first distance L1 and the second distance L2 become excessively large, the heat transfer efficiency between the neighboring (adjacent) first heat dissipation sheets 115 and the neighboring (adjacent) second heat dissipation sheets 125 may be reduced. Additionally, when the first distance L1 and the second distance L2 become excessively small, the process difficulty may increase. Each of the neighboring (adjacent) first heat dissipation sheets 115 and the neighboring (adjacent) second heat dissipation sheets 125 are spaced apart by the first distance L1 and the second distance L2 of the above range, so that the process difficulty may be reduced and the heat transfer efficiency may be improved.

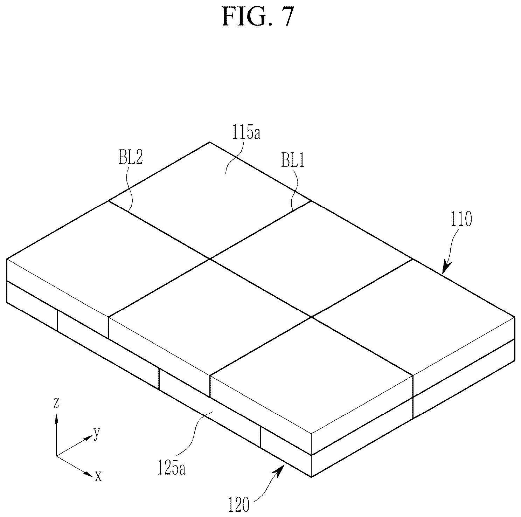

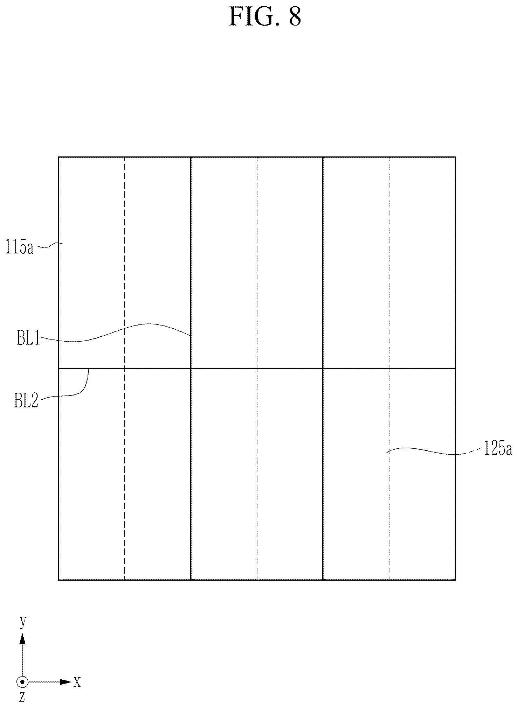

FIG. 7 is a schematic perspective view of an embodiment of a heat dissipation member applied to a display device. FIG. 8 is a schematic top plan view of the heat dissipation member shown in FIG. 7.

Referring to FIGS. 7 and 8, the first heat dissipation layer 110 may include a plurality of first heat dissipation sheets 115a partitioned by a first boundary line BL1 extending in the second direction (y), and the second heat dissipation layer 120 may include a second heat dissipation sheet 125a covering the first boundary line BL1. In an embodiment, the second heat dissipation sheet 125a may partially overlap both of two first heat dissipation sheets 115a next (adjacent) to each other with respect to the first boundary line BL1 and may be disposed while overlapping the first boundary line BL1, for example.

One second heat dissipation sheet 125a may cover the first boundary line BL1 extending in the second direction (y). In an embodiment, an edge extending in the second direction (y) of the first heat dissipation sheet 115a and an edge extending in the second direction (y) of the second heat dissipation sheet 125a may be misaligned with each other, for example. Each of the two first heat dissipation sheets 115a next (adjacent) to each other in the first direction (x) may partially overlap the one second heat dissipation sheet 125a. In an embodiment, the two first heat dissipation sheets 115a next (adjacent) to each other with the first boundary line BL1 extending in the second direction (y) interposed therebetween may overlap the one second heat dissipation sheet 125a, for example. Accordingly, the second heat dissipation sheet 125a overlapping the two first heat dissipation sheets 115a next (adjacent) in the first direction (x) may transfer heat between the two first heat dissipation sheets 115a next (adjacent) to the first boundary line BL1 interposed therebetween, so that the heat transfer rate in the first direction (x) may be improved.

An edge extending in the first direction (x) of the first heat dissipation sheet 115a may be aligned with an edge extending in the first direction (x) of the second heat dissipation sheet 125a. The edge extending in the first direction (x) of the first heat dissipation sheet 115a may be aligned with the edge extending in the first direction (x) of the second heat dissipation sheet 125a without misalignment. In an embodiment, the first heat dissipation layer 110 may include a plurality of first heat dissipation sheets 115a partitioned into a second boundary line BL2 extending in the first direction (x), and the second heat dissipation sheet 125a of the second heat dissipation layer 120 may not cover the second boundary line BL2, for example. Accordingly, by reducing the heat transfer rate between the first heat dissipation sheets 115a next (adjacent) to each other in the second direction (y), the heat transfer rate in the first direction (x) may be relatively improved when heat sources are on opposite sides with the second boundary line BL2 interposed therebetween. Therefore, heat may be transferred so as to show uniform heat distribution in both the first direction (x) and the second direction (y).

With reference to FIGS. 7 and 8, it has been stated that the edge of the first heat dissipation sheet 115a and the edge of the second heat dissipation sheet 125a extending in the first direction (x) are aligned with each other, and the edge of the first heat dissipation sheet 115a and the edge of the second heat dissipation sheet 125a extending in the second direction (y) are misaligned with each other. However, the edge of the first heat dissipation sheet and the edge of the second heat dissipation sheet extending in the first direction (x) may be misaligned with each other, and the edge of the first heat dissipation sheet and the edge of the second heat dissipation sheet extending in the second direction (y) may be aligned with each other.

In an embodiment, the first heat dissipation layer may include a plurality of first heat dissipation sheets partitioned by the second boundary lines extending in the first direction (x), and the second heat dissipation layer may include the second heat dissipation sheet covering the second boundary lines, for example.

One second heat dissipation sheet may cover the second boundary line extending in the first direction (x). In an embodiment, an edge extending in the first direction (x) of the first heat dissipation sheet and an edge extending in the first direction (x) of the second heat dissipation sheet may be misaligned with each other, for example. Two first heat dissipation sheets next (adjacent) to each other in the second direction (y) may overlap one second heat dissipation sheet. In an embodiment, two first heat dissipation sheets next (adjacent) to each other with the second boundary line extending in the first direction (x) interposed therebetween may overlap one second heat dissipation sheet, for example. Accordingly, the second heat dissipation sheet overlapping the two first heat dissipation sheets next (adjacent) to each other in the second direction (y) may transfer heat between the two first heat dissipation sheets next (adjacent) to each other with the second boundary line interposed therebetween, thereby improving the heat transfer rate in the second direction (y).

The edge extending in the second direction (y) of the first heat dissipation sheet may be aligned with the edge extending in the second direction (y) of the second heat dissipation sheet. The edge extending in the second direction (y) of the first heat dissipation sheet may be aligned with the edge extending in the second direction (y) of the second heat dissipation sheet without misalignment. In an embodiment, the first heat dissipation layer may include a plurality of first heat dissipation sheets partitioned by the first boundary line extending in the second direction (y), and the second heat dissipation sheets of the second heat dissipation layer may not cover the first boundary line, for example. Accordingly, by reducing the heat transfer rate between the first heat dissipation sheets 115 next (adjacent) to each other in the first direction (x), the heat transfer rate in the second direction (y) may be relatively improved when heat sources are on opposite sides with the first boundary line BL1 interposed therebetween. Therefore, heat may be transferred so as to show a uniform heat distribution in both the first direction (x) and the second direction (y).

In an embodiment, at least one edge of the first heat dissipation sheet may be misaligned with at least one edge of the second heat dissipation sheet. In an embodiment, one, two, three, or four edges of the first heat dissipation sheet may be misaligned with the edges of the second heat dissipation sheet, for example. Accordingly, even when the areas of the first heat dissipation sheet and the second heat dissipation sheet are different from each other, heat between the first heat dissipation sheets separated by at least one boundary line may be efficiently transferred through the second heat dissipation sheet.

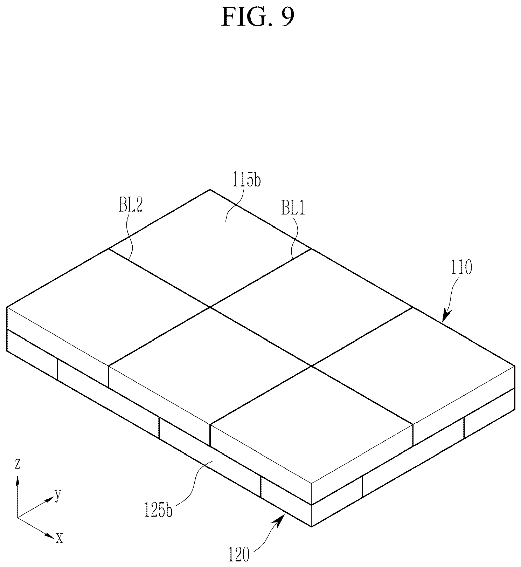

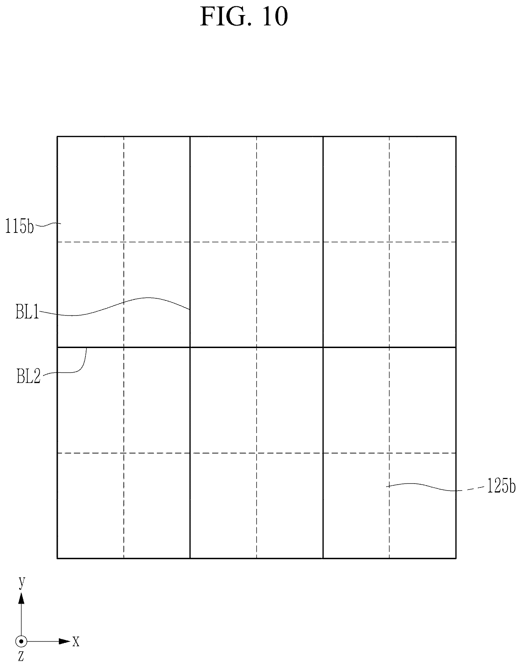

FIG. 9 is a schematic perspective view of an embodiment of a heat dissipation member applied to a display device. FIG. 10 is a schematic top plan view of the heat dissipation member shown in FIG. 9.

Referring to FIGS. 9 and 10, the first heat dissipation layer 110 includes a plurality of first heat dissipation sheets 115b partitioned by the first boundary line BL1 extending in the second direction (y) and the second boundary line BL2 extending in the first direction (x), and the second heat dissipation sheets may cover both the first boundary line BL1 and the second boundary line BL2. In an embodiment, a second heat dissipation sheet 125b may partially overlap all four first heat dissipation sheets 115b next (adjacent) to each other with respect to the first boundary line BL1 and the second boundary line BL2, and may be disposed to overlap both the first boundary line BL1 and the second boundary line BL2, for example.

One second heat dissipation sheet 125b may cover both the first boundary line BL1 extending in the second direction (y) and the second boundary line BL2 extending in the first direction (x). In an embodiment, the edge extending in the first direction (x) and the edge extending in the second direction (y) of the first heat dissipation sheet 115b may be misaligned with each of the edge extending in the first direction (x) and the edge extending in the second direction (y) of the second heat dissipation sheet 125b, for example. Each of the four first heat dissipation sheets 115b next (adjacent) to each other in the first direction (x) and the second direction (y) may partially overlap one second heat dissipation sheet 125b. In an embodiment, two first heat dissipation sheets 115b next (adjacent) to each other with the first boundary line BL1 extending in the second direction (y) interposed therebetween may overlap one second heat dissipation sheet 125b, for example. Additionally, each of the two first heat dissipation sheets 115b next (adjacent) to each other with the first boundary line BL1 interposed therebetween and both of the two first heat dissipation sheets 115b next (adjacent) to each other with the second boundary line BL2 interposed therebetween may overlap one second heat dissipation sheet 125b. Accordingly, heat between the first heat dissipation sheets 115b separated by the first boundary line BL1 and the second boundary line BL2 may be transferred through one second heat dissipation sheet 125b. Therefore, even when a plurality of first heat dissipation sheets 115b are used, the heat transfer efficiency may be improved.

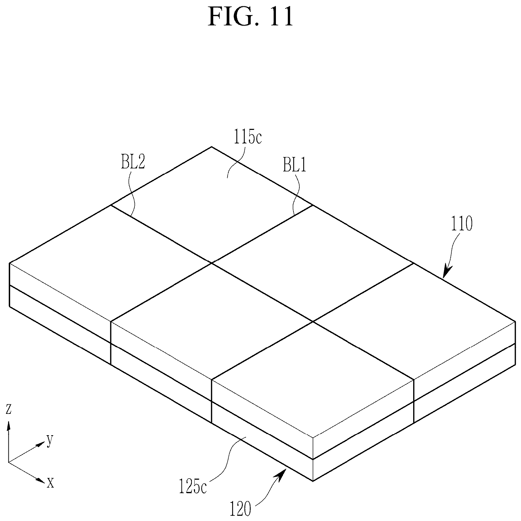

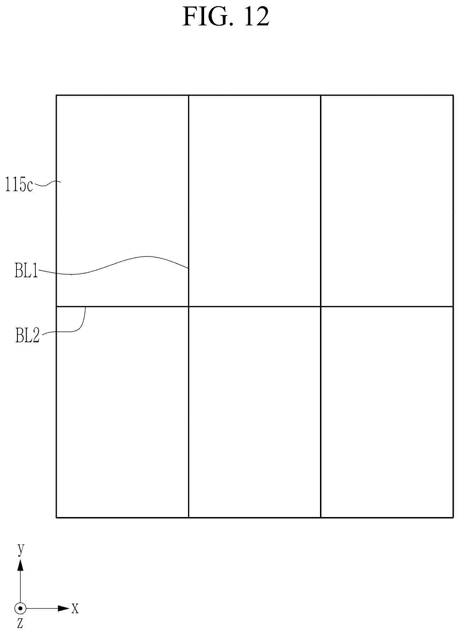

FIG. 11 is a schematic perspective view of an embodiment of a heat dissipation member applied to a display device. FIG. 12 is a schematic top plan view of the heat dissipation member shown in FIG. 11.

Referring to FIGS. 11 and 12, the first heat dissipation layer 110 may include a plurality of first heat dissipation sheets 115c partitioned by the first boundary line BL1 extending in the second direction (y) and the second boundary line BL2 extending in the first direction (x). A second heat dissipation sheet 125c may not cover the first boundary line BL1 or the second boundary line BL2.

Any one first heat dissipation sheet 115c of the first heat dissipation layer 110 may overlap only one second heat dissipation sheet 125c of the second heat dissipation layer 120. Edges extending in the first direction (x) and the second direction (y) of the first heat dissipation sheet 115c may be aligned with the edges extending in the first direction (x) and the second direction (y) of the second heat dissipation sheet 125c, respectively. In an embodiment, all edges of the first heat dissipation sheet 115c may not be misaligned with all edges of the second heat dissipation sheet 125c, for example. Accordingly, the heat transfer rate in a third direction (z), which is perpendicular to both the first direction (x) and the second direction (y), may relatively increase. Accordingly, when there is a heat source corresponding to each first heat dissipation sheet 115, the temperature around the heat source may be reduced by rapidly transferring heat in the third direction (z).

In an embodiment, the first heat dissipation sheet and the second heat dissipation sheet may include a vapor chamber ("VC"). The VC is a heat transfer device that has a flat plate shape and includes or consists of a liquid refrigerant inside. The VC may transfer or disperse heat as the liquid refrigerant inside is vaporized by a heat source and phase-transformed into a gaseous refrigerant, and the gaseous refrigerant liquefies into a liquid refrigerant as it circulates inside the chamber.

The *VC* transfers heat as the gaseous refrigerant that has been vaporized from the liquid refrigerant and phase-transformed into a gaseous state, thereby allowing for a relatively high rate of heat transfer in a horizontal direction (e.g., first direction (x), second direction (y), etc.). The first heat dissipation sheet and the second heat dissipation sheet may include *VCs,* so that heat transfer efficiency in the horizontal direction may be improved.

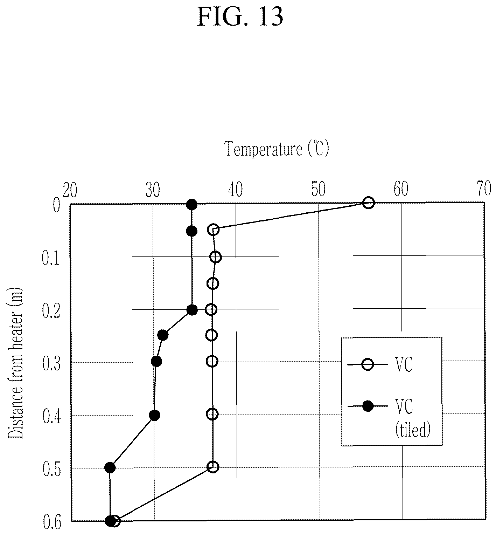

FIG. 13 is a graph showing the temperature change according to the distance from the heat source when a *VC* is used. FIG. 13 is a graph showing the temperature change according to the vertical distance from the heat source when the *VC* is used, when the *VC* (tiled) is used in two layers, and when the *VC* is used in a single layer (VC).

Referring to FIG. 13, when the *VC* (tiled) was used in two layers, the temperature decreased at all vertical distances from the heat source compared to when the *VC* was used in a single layer (VC). In addition, when the *VC* was used in a single layer (VC), there was a rapid temperature rise at the heat source, but when the *VC* (tiled) was used in two layers, the temperature was similar to that when the *VC* was separated from the heat source by 0.2 m in the vertical direction.

Therefore, when the *VC* (tiled) is used in two layers, it may be seen that the degree of heat dispersion is improved and the temperature at the heat source is reduced compared to when the *VC* is used in a single layer (VC).

In an embodiment, at least one of the first heat dissipation sheet and the second heat dissipation sheet may include a VC, and a remaining (the other) one may include a pulsating heat pipe ("PHP"). The PHP is a heat transfer device that includes tubes through which liquid and gas may be repeatedly circulated. As the liquid refrigerant and the gaseous refrigerant move together inside the tube of the PHP, the refrigerants may transfer or disperse heat by repeatedly vaporizing and liquefying. The PHP may have a constant temperature in a vertical direction (e.g., the third direction (z)), allowing for a relatively fast heat transfer rate in the vertical direction.

When the first heat dissipation sheet 115 includes a VC and the second heat dissipation sheet 125 includes a *PHP,* heat rapidly transferred in the horizontal direction through the first heat dissipation sheet 115 may be dispersed in the vertical direction through the second heat dissipation sheet. In an embodiment, when the heat source of the display panel is concentrated at the center of the first heat dissipation sheet 115, the heat may be effectively dispersed, for example.

When the first heat dissipation sheet includes a *PHP* and the second heat dissipation sheet includes a *VC*, heat rapidly transferred in the vertical direction through the first heat dissipation sheet may be dispersed in the horizontal direction through the second heat dissipation sheet. In an embodiment, when the heat source of the display panel is distributed over the entirety of the first heat dissipation sheet, the heat may be effectively dispersed, for example.

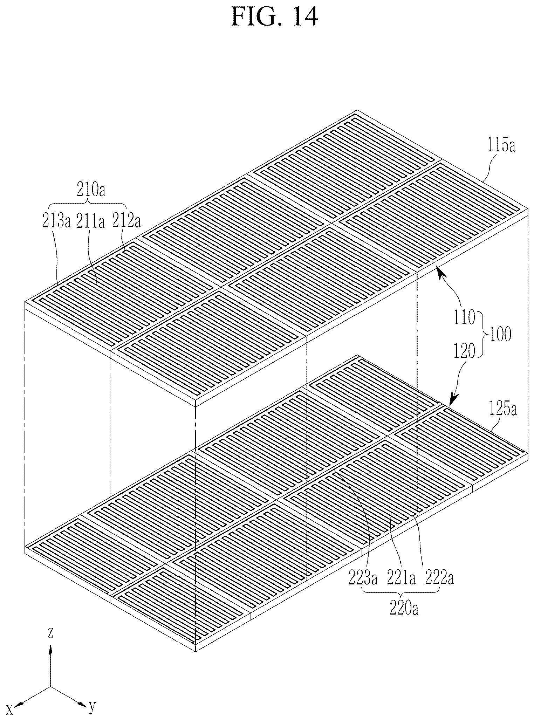

FIGS. 14 to 21 are schematic exploded perspective views of heat dissipation members applied to display devices according to various embodiments.

The heat dissipation member 100 may include the first heat dissipation layer 110 including a plurality of first heat dissipation sheets 115a arranged in the first direction (x) and a plurality of first heat dissipation sheets 115a arranged in the second direction (y). Referring to FIG. 14, the first heat dissipation layer 110 may include three first heat dissipation sheets 115a arranged in the first direction (x) and two first heat dissipation sheets 115a arranged in the second direction (y). The heat dissipation member 100 may include the second heat dissipation layer 120 including three second heat dissipation sheets 125a arranged in the first direction (x) and two second heat dissipation sheets 125a arranged in the second direction (y).

The first heat dissipation sheet 115a and the second heat dissipation sheet 125a may include *PHPs.* The first heat dissipation sheet 115a may include a first pipe 210a including a first straight flow path 211a, a first connecting flow path 212a, and a first closed flow path 213a. The first pipe 210a may be a closed-loop *PHP.* The first straight flow path 211a is connected through the first connecting flow path 212a, and the first closed flow path 213a seals the first straight flow path 211a or the first connecting flow path 212a, so that the first pipe 210a may have a closed loop.

The second heat dissipation sheet 125a may include a second pipe 220a including a second straight flow path 221a, a second connecting flow path 222a, and a second closed flow path 223a. The second pipe 220a may be a closed-loop *PHP.* The second straight flow path 221a is connected through the second connecting flow path 222a, and the second closed flow path 223a seals the second straight flow path 221a or the second connecting flow path 222a, so that the second pipe 220a may have a closed loop.

The extension directions of the first straight flow path 211a and the second straight flow path 221a may be parallel to each other. Both the first straight flow path 211a and the second straight flow path 221a may extend in the second direction (y).

"Parallel to each other" may be used to mean that the extension direction of the first straight flow path 211a and the extension direction of the second straight flow path 221 are physically parallel and are inclined at an angle of -2.5° to 2.5°, -1° to 1°, -0.5° to 0.5°, or 0°. In an embodiment, when the first straight flow path 211a and the second straight flow path 221 are disposed to overlap, "parallel to each other" may be used to mean a case where the angle between the first straight flow path 211a and the second straight flow path 221 is 0° to 5°, 0° to 3°, 0° to 1°, or 0°, for example.

Two first heat dissipation sheets 115a next (adjacent) to each other in the first direction (x) may be partitioned by the first boundary line extending in the second direction (y), and the second heat dissipation sheet 125a may cover the first boundary line. Additionally, both the first straight flow path 211a and the second straight flow path 221a may extend in the second direction (y). Accordingly, the second straight flow path 221a of the second heat dissipation sheet 125a may be disposed between the first straight flow path 211a of the first heat dissipation sheet 115a. Accordingly, a moving speed of heat between the first heat dissipation sheet 115a and the second heat dissipation sheet 125a may be improved. Therefore, the rate at which the heat input to the first heat dissipation sheet 115a moves to the second heat dissipation sheet 125a and the neighboring (adjacent) first heat dissipation sheet 115a may be improved, and the dispersion rate of the heat input from the heat source to the first heat dissipation sheet 115a may be improved.

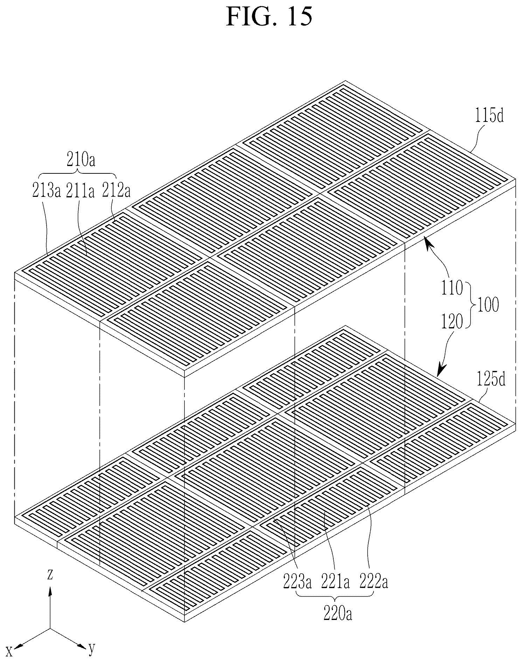

Referring to FIG. 15, two first heat dissipation sheets 115d next (adjacent) to each other in the second direction (y) may be partitioned by the second boundary line extending in the first direction (x), and the second heat dissipation sheet 125d may cover the second boundary line. Additionally, both the first straight flow path 211a and the second straight flow path 221a may extend in the second direction (y). Accordingly, the first closed flow path 213a of the first heat dissipation sheet 115d may be disposed across the second straight flow path 221a of the second heat dissipation sheet 125d, and the second closed flow path 223a of the second heat dissipation sheet 125d may be disposed across the first straight flow path 211a of the first heat dissipation sheet 115d. Therefore, the rate at which the heat input to the first heat dissipation sheet 115d moves to the second heat dissipation sheet 125d and the rate at which the heat moved to the second heat dissipation sheet 125d moves to the neighboring (adjacent) first heat dissipation sheet 115d may be improved, and the dispersion rate of the heat from the heat source may be improved.

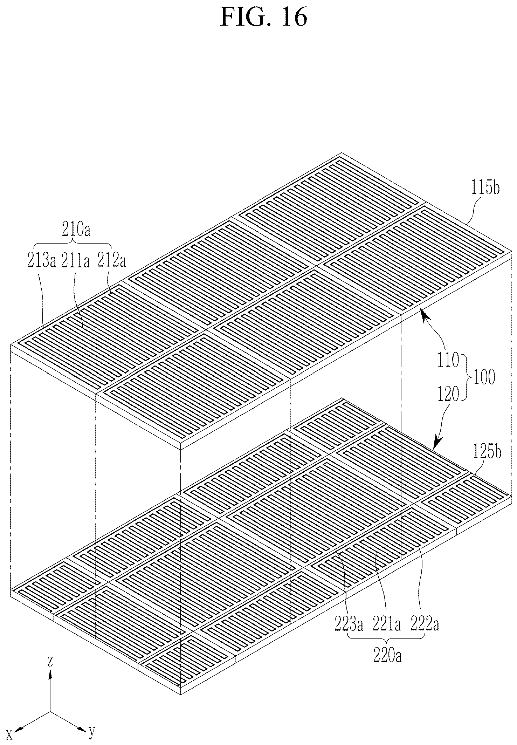

Referring to FIG. 16, two first heat dissipation sheets 115b next (adjacent) to each other in the first direction (x) may be partitioned by the first boundary line extending in the second direction (y). Two first heat dissipation sheets 115b next (adjacent) to each other in the second direction (y) may be partitioned by the second boundary line extending in the first direction. One second heat dissipation sheet 125b may cover both the first boundary line and the second boundary line. Both the first straight flow path 211a and the second straight flow path 221a may extend in the second direction (y). Accordingly, the second straight flow path 221a of the second heat dissipation sheet 125b may be disposed between the first straight flow path 211a of the first heat dissipation sheet 115b. Additionally, the first closed path 213a may be disposed across the second straight flow path 221a, and the second closed path 223a may be disposed across the first straight flow path 211a. Accordingly, the heat transfer rate from the first heat dissipation sheet 115b to the second heat dissipation sheet 125b may be further improved. Accordingly, the rate at which the heat input to the first heat dissipation sheet 115b moves to the second heat dissipation sheet 125b and the rate at which the heat moved to the second heat dissipation sheet 125b moves to the neighboring (adjacent) first heat dissipation sheet 115b may be further improved. Additionally, the dispersion rate of the heat from the heat source may be further improved.

In FIGS. 14 to 16, both the first straight flow path and the second straight flow path are shown as extending in the second direction (y), but the first straight flow path and the second straight flow path may extend parallel to a direction other than the second direction (y). In an embodiment, both the first straight flow path and the second straight flow path may extend in the first direction (x), for example.

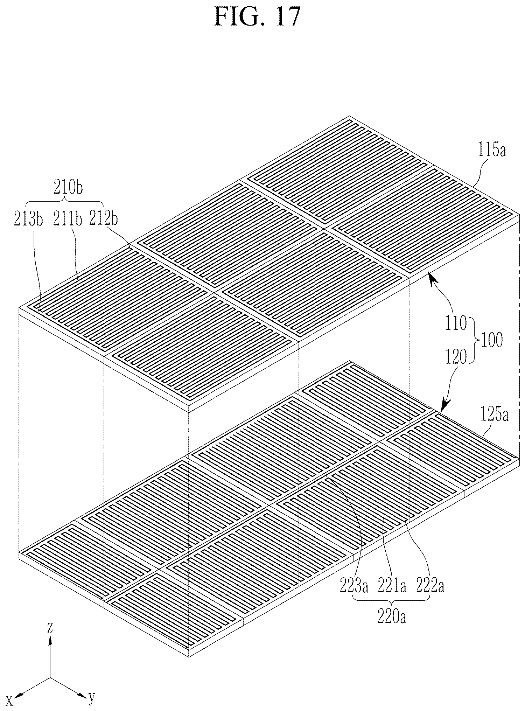

Referring to FIG. 17, the first straight flow path 211b and the second straight flow path 221a may intersect each other. In an embodiment, the first straight flow path 211b may extend in the first direction (x), and the second straight flow path 221a may extend in the second direction (y), for example.

Two first heat dissipation sheets 115a next (adjacent) to each other in the first direction (x) may be partitioned by the first boundary line extending in the second direction (y), and the second heat dissipation sheet 125a may cover the first boundary line. Additionally, the first straight flow path 211b may extend in the first direction (x), and the second straight flow path 221a may extend in the second direction (y). The first straight flow path 211b and the second straight flow path 221a may intersect each other. Accordingly, heat from the first straight flow path 211b may be simultaneously moved to the second straight flow path 221a, so that the heat transfer rate from the first heat dissipation sheet 115a to the second heat dissipation sheet 125a may be improved. Therefore, the dispersion rate of the heat input from the heat source to the first heat dissipation sheet 115a may be improved.

In FIG. 17, the first straight flow path 211b of a first pipe 210b is illustrated as extending in the first direction (x) and the second straight flow path 221a is illustrated as extending in the second direction (y), but when the first straight flow path and the second straight flow path intersect, the extension direction is not limited. In an embodiment, the first straight flow path may extend in the second direction (y) and the second straight flow path may extend in the first direction (x), for example. The first pipe 210b may further include a first connecting flow path 212b and a first closed flow path 213b.

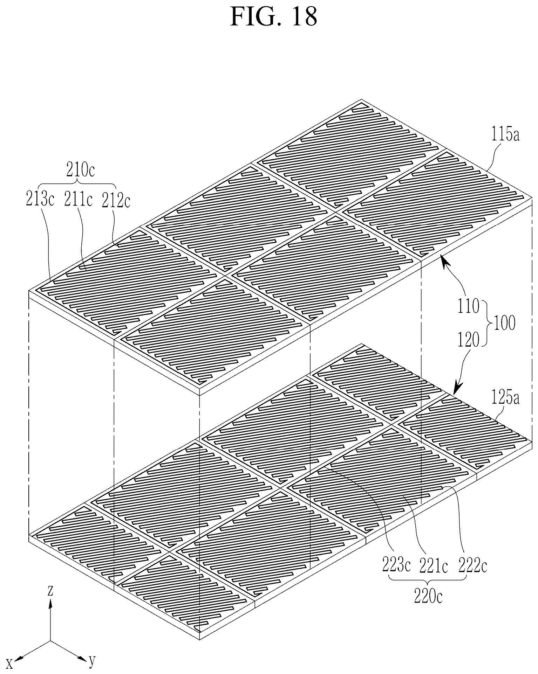

Referring to FIG. 18, a first straight flow path 211c of a first pipe 210c and a second straight flow path 221c of a second pipe 220c may extend in the diagonal direction with respect to the first direction (x) and the second direction (y). Additionally, the extension directions of the first straight flow path 211c and the second straight flow path 221c may be parallel to each other. The first pipe 210c may further include a first connecting flow path 212c and a first closed flow path 213c, and the first pipe 220c may further include a first connecting flow path 222c and a first closed flow path 223c.

Two first heat dissipation sheets 115a next (adjacent) to each other in the first direction (x) may be partitioned by the first boundary line extending in the second direction (y), and the second heat dissipation sheet 125a may cover the first boundary line. Additionally, both the first straight flow path 211c and the second straight flow path 221c may extend in the diagonal direction parallel to the first direction (x) and the second direction (y). Accordingly, the dispersion rate of the heat from the heat source disposed at the corner area of the first heat dissipation sheet 115 may be improved.

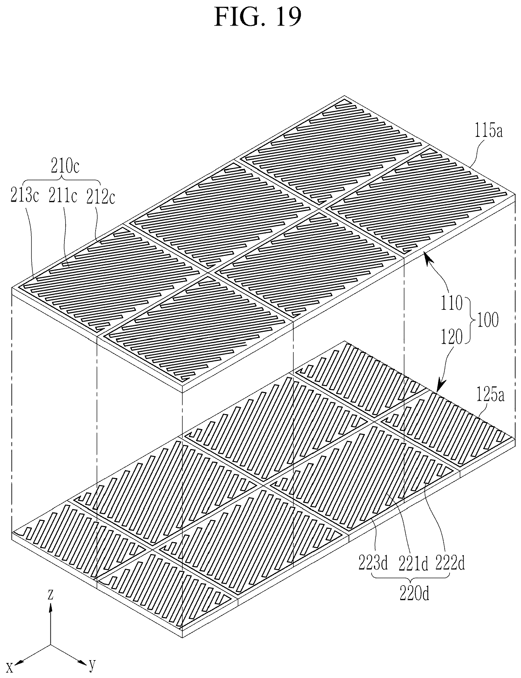

Referring to FIG. 19, the first straight flow path 211c of the first pipe 210c and a second straight flow path 221d of the second pipe 220d extend in the diagonal direction with respect to the first direction (x) and the second direction (y), and the extension directions of the first straight flow path 211c and the second straight flow path 221d may intersect. The second pipe 220d may further include a second connecting flow path 222d and a second closed flow path 223d.

Two first heat dissipation sheets 115a next (adjacent) to each other in the first direction (x) may be partitioned by the first boundary line extending in the second direction (y), and the second heat dissipation sheet 125a may cover the first boundary line. Additionally, both the first straight flow path 211c and the second straight flow path 221d may extend in the diagonal direction to intersect with respect to the first direction (x) and the second direction (y). The heat of one first straight flow path 211c may move simultaneously to a plurality of second straight flow paths 221d, and the heat of one second straight flow path 221d may move simultaneously to a plurality of first straight flow paths 211c. Accordingly, the moving speed of the heat from the first heat dissipation sheet 115a to the second heat dissipation sheet 125a and the moving speed of the heat from the second heat dissipation sheet 125a to the neighboring (adjacent) first heat dissipation sheet 115a may be improved. Therefore, the dispersion rate of the heat input from the heat source to the first heat dissipation sheet 115a to the second heat dissipation sheet 125a, and the dispersion rate of the heat moved to the second heat dissipation sheet 125a to a neighboring (adjacent) first heat dissipation sheet 115a, may be improved.

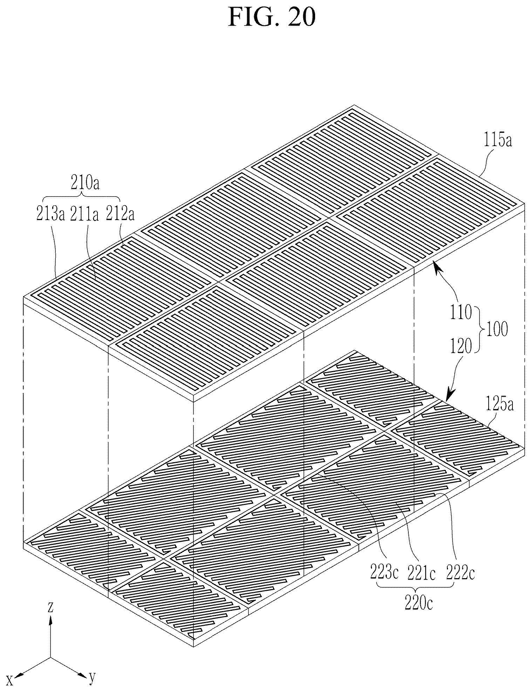

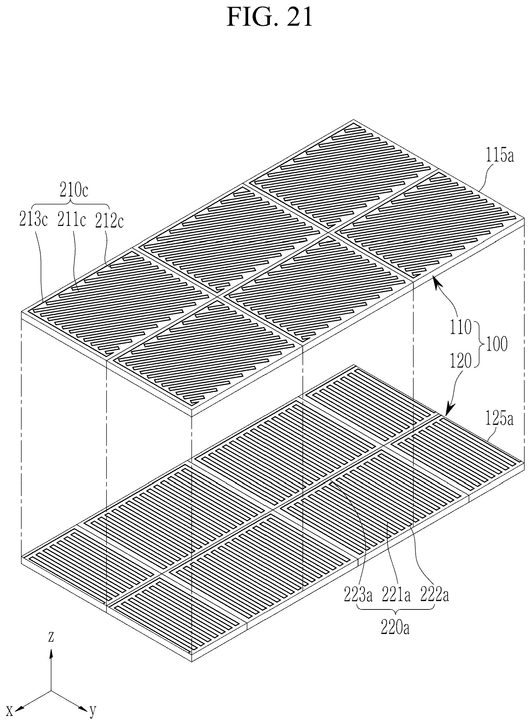

Referring to FIGS. 20 and 21, one of the first straight flow path and the second straight flow path may extend in the diagonal direction with respect to the first direction (x) and the second direction (y), and a remaining (the other) one may extend in the first direction (x) or the second direction (y).

Referring to FIG. 20, two first heat dissipation sheets 115a next (adjacent) to each other in the first direction (x) may be partitioned by the first boundary line extending in the second direction (y), and the second heat dissipation sheet 125a may cover the first boundary line. Additionally, the first straight flow path 211a may extend in either the first direction (x) or the second direction (y), and the second straight flow path 221c may extend in the diagonal direction with respect to the first direction (x) and the second direction (y).

Two first heat dissipation sheets 115a next (adjacent) to each other in the first direction (x) may be partitioned by the first boundary line extending in the second direction (y), and the second heat dissipation sheet 125a may cover the first boundary line.

Referring to FIG. 21, the first straight flow path 211c may extend in the diagonal direction with respect to the first direction (x) and the second direction (y), and the second straight flow path 221a may extend in either the first direction (x) or the second direction (y).

In FIGS. 17 to 21, the second heat dissipation sheet 125 is illustrated as extending in the second direction (y) to cover the first boundary line that partitions the first heat dissipation sheets next to each other, but the arrangement of the first heat dissipation sheet and the second heat dissipation sheet is not limited thereto. In an embodiment, the second heat dissipation sheet may cover the second boundary line extending in the first direction (x) that partitions two first heat dissipation sheets next (adjacent) to each other in the second direction (y), for example. One second heat dissipation sheet may cover both the first boundary line and the second boundary line.

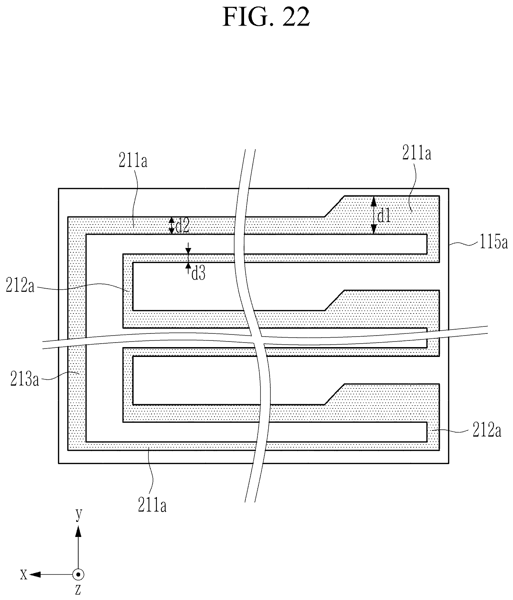

FIG. 22 is a schematic top plan view of an embodiment of a heat dissipation sheet. The heat dissipation sheet of FIG. 22 may be applied to a structure of a heat dissipation sheet in which a pipe extends parallel to an edge of the heat dissipation sheet. In an embodiment, the heat dissipation sheet of FIG. 22 may be applied to at least one of the first heat dissipation sheet 115a and the second heat dissipation sheet 125a of FIG. 14, the first heat dissipation sheet 115d and the second heat dissipation sheet 125d of FIG. 15, the first heat dissipation sheet 115b and the second heat dissipation sheet 125b of FIG. 16, the first heat dissipation sheet 115a and the second heat dissipation sheet 125a of FIG. 17, the first heat dissipation sheet 115a of FIG. 20, and the second heat dissipation sheet 125a of FIG. 21, for example. In FIG. 22, the first straight flow path 211a is shown as being extended in the second direction (y), but the type and extension direction of the straight flow path are not limited thereto. In an embodiment, the straight flow path may be the second straight flow path 221, for example. In an embodiment, the first straight flow path 211a and the second straight flow path 221 may extend in the second direction (y) and may extend in the diagonal direction with respect to the first direction (x) and the second direction (y), for example.

Referring to FIG. 22, at least one of the cross-sections of the cross-section of the first straight flow path 211a may include a first region, a second region, and a third region having different diameters from each other.

The first region may refer to a region having a cross-section with a first diameter d1.

The second region may refer to a region having a cross-section with a second diameter d2. The third region may refer to a region having a cross-section with a third diameter d3. The first diameter d1 may be larger than the second diameter d2 and the third diameter d3. The second diameter d2 may be smaller than the first diameter d1 and larger than the third diameter d3. The third diameter d3 may be smaller than the first diameter d1 and the second diameter d2.

As the diameter of the flow path increases, the flow rate of a fluid may decrease and the pressure may increase. Accordingly, as the diameter of the flow path increases, the temperature may decrease. Since the first straight flow path 211a includes all regions having different diameters d1, d2, and d3, the temperature of the fluid (e.g., refrigerant) passing through the first straight flow path 211a may be reduced. In an embodiment, the temperature may decrease as the fluid moves from the third region having the third diameter d3 to the second region having the second diameter d2, for example. Additionally, the temperature may decrease as the fluid moves from the second region having the second diameter d2 to the first region having the first diameter d1. Accordingly, as heat from the heat source passes through the pipe, not only is the heat dispersed, but also the temperature inside the pipe may decrease. Therefore, the rate of temperature reduction around the heat source may be further improved.

In FIGS. 7 to 12 and FIGS. 14 to 21, the heat dissipation member is illustrated as including the first heat dissipation layer and the second heat dissipation layer. Additionally, each of the first heat dissipation layer and the second heat dissipation layer are illustrated as including a plurality of first heat dissipation sheets and a plurality of second heat dissipation sheets. However, the heat dissipation member may include three or more heat dissipation layers, and each heat dissipation layer may include only one heat dissipation sheet.

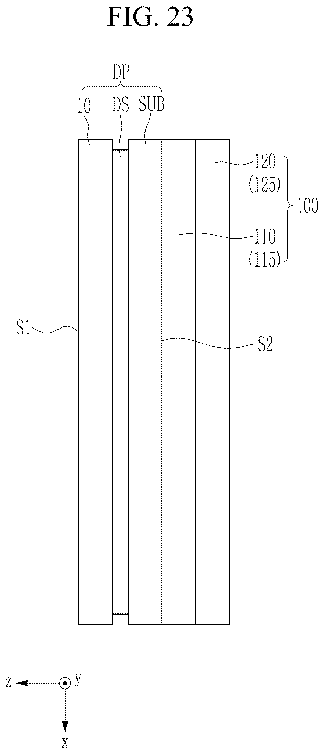

FIGS. 23 to 25 are schematic side views of an embodiment of display devices.

Referring to FIG. 23, the display panel DP may include the first surface S1 and the second surface S2 opposing each other, and the heat dissipation member 100 may be disposed on the second surface S2. The heat dissipation member 100 may include the first heat dissipation layer 110 and the second heat dissipation layer 120. The first heat dissipation layer 110 may include only one first heat dissipation sheet 115. The second heat dissipation layer 120 may include only one second heat dissipation sheet 115.

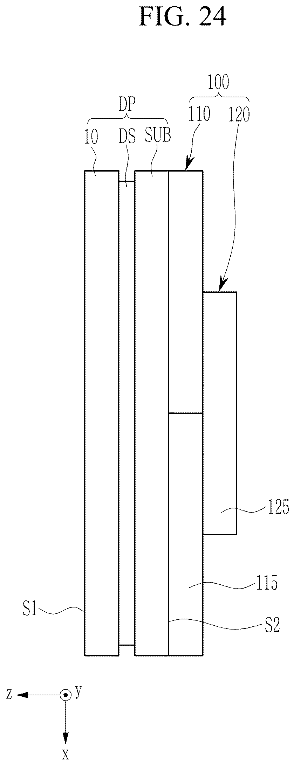

Referring to FIG. 24, the heat dissipation member 100 may be disposed on the second surface S2 of the display panel DP. The heat dissipation member 100 may include a first heat dissipation layer 110 and a second heat dissipation layer 120. The first heat dissipation layer 110 may include a plurality of first heat dissipation sheets 115 extending in the first direction (x). The first heat dissipation layer 110 may include a plurality of first heat dissipation sheets 115 extending in the second direction (y). The second heat dissipation layer 120 may include one second heat dissipation sheet 125. The second heat dissipation layer 120 may have only one second heat dissipation sheet 125 disposed in the first direction (x) and may have a plurality of second heat dissipation sheets 125 disposed in the second direction (y).

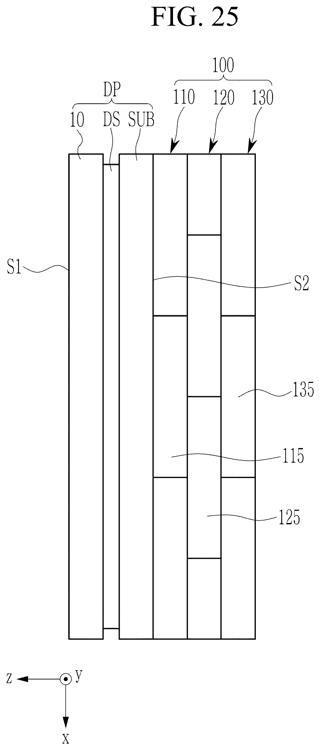

Referring to FIG. 25, the heat dissipation member 100 may be disposed on the second surface S2 of the display panel DP. The heat dissipation member 100 may include the first heat dissipation layer 110, the second heat dissipation layer 120, and the third heat dissipation layer 130. The first heat dissipation layer 110 may include a plurality of first heat dissipation sheets 115 extending in the first direction (x). The second heat dissipation layer 120 may include a plurality of second heat dissipation sheets 125 extending in the first direction (x). The third heat dissipation layer 130 may include a plurality of third heat dissipation sheets 135 extending in the first direction (x). Each of the first heat dissipation layer 110, the second heat dissipation layer 120, and the third heat dissipation layer 130 may include a plurality of first heat dissipation sheets 115, a plurality of second heat dissipation sheets 125, and a plurality of third heat dissipation sheets 135 extending in the second direction (y).

The arrangement structure of the first heat dissipation sheet 115, the second heat dissipation sheet 125, and the third heat dissipation sheet 135 is not limited. In an embodiment, at least two of the arrangement structures of the first heat dissipation sheet 115, the second heat dissipation sheet 125, and the third heat dissipation sheet 135 may be the same, and all three arrangement structures may be different, for example.

The first heat dissipation sheet 115 and the second heat dissipation sheet 125 described in FIGS. 23 to 25, and the third heat dissipation sheet 135 described in FIG. 25 may include at least one of a VC and a *PHP.* In an embodiment, both the first heat dissipation sheet 115 and the second heat dissipation sheet 125 may include VCs, for example. Both the first heat dissipation sheet 115 and the second heat dissipation sheet 125 may include *PHPs.* Either the first heat dissipation sheet 115 or the second heat dissipation sheet 125 may include a VC, and a remaining (the other) one may include a *PHP.* Additionally, independent of the first heat dissipation sheet 115 and the second heat dissipation sheet 125, the third heat dissipation sheet 135 may include either a VC or a *PHP.*

When the first heat dissipation sheet 115 and the second heat dissipation sheet 125 include *PHPs,* the arrangement structure of the pipes included in the *PHPs* may be substantially the same as the arrangement structure of the pipes described with reference to FIGS. 14 to 21.

The first heat dissipation sheet 115, the second heat dissipation sheet 125, and the third heat dissipation sheet 135 may all include a *PHP.* In this case, the pipe arrangement structure included in the third heat dissipation sheet 135 may be the same as the pipe arrangement structure included in at least one of the first heat dissipation sheet 115 and the second heat dissipation sheet 125. The pipe arrangement structure included in the third heat dissipation sheet 135 may be different from both the pipe arrangement structures included in the first heat dissipation sheet 115 and the second heat dissipation sheet 125.

A heat dissipation member including the first heat dissipation layer and the second heat dissipation layer described above may be applied to an electronic device. A display device in an embodiment may be applied to various electronic devices. An electronic device in an embodiment may include the display device, and may further include modules or devices having additional functions other than the display device.

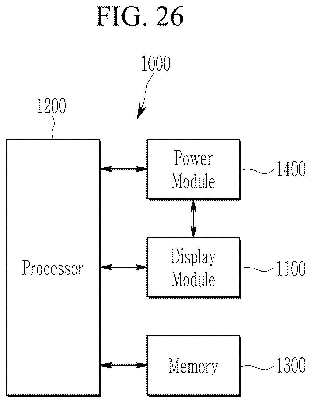

FIG. 26 is a block diagram of an embodiment of an electronic device. Referring to FIG. 26, the electronic device 1000 in an embodiment may include a display module 1100, a processor 1200, a memory 1300, and a power module 1400.

The processor 1200 may include at least one of a central processing unit ("CPU"), an application processor ("AP"), a graphic processing unit ("GPU"), a communication processor ("CP"), an image signal processor ("ISP"), and a controller

The memory 1300 may store data information desired for operations of the processor 1200 or the display module 1100. When the processor 1200 executes an application stored in the memory 1300, video data signals and/or input control signals are transmitted to the display module 1100, and the display module 1100 may process the received signals to output video information through the display screen.

The power module 1400 may include a power supply module such as a power adapter or battery device, and a power conversion module that converts the power supplied by the power supply module to generate the power desired for the operation of the electronic device 1000.

At least one of components of the electronic device 1000 may be included within the display device according to the above-described embodiments. Additionally, some of the individual modules that are functionally included within a single module may be incorporated into the display device, while others may be provided separately from the display device. In an embodiment, the display device may include the display module 1100, while the processor 1200, memory 1300, and power module 1400 may be provided in a form of other devices within the electronic device 1000 that are not part of the display device, for example.

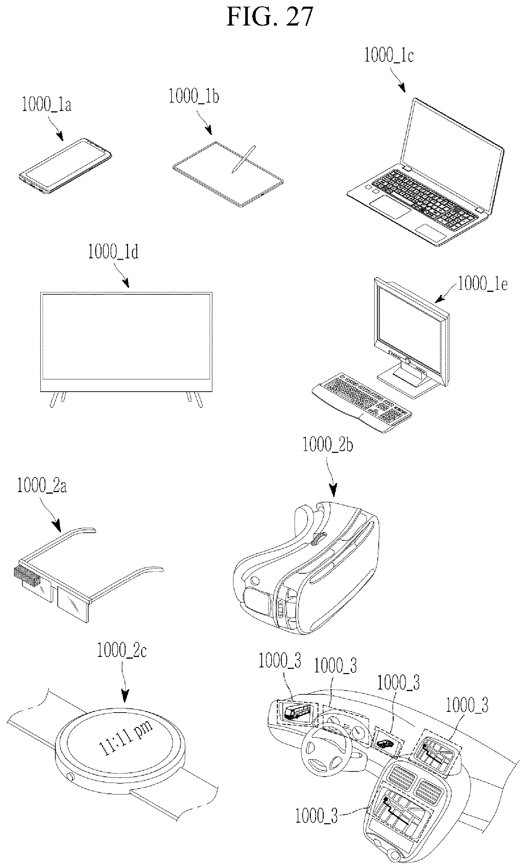

FIG. 27 shows schematic diagrams of electronic devices according to various embodiments. Referring to FIG. 27, various electronic devices with the display device in the embodiments may include not only image display electronic devices such as smartphones 1000_1a, tablet PCs 1000_1b, laptops 1000_1c, televisions ("TVs") 1000_1d, desktop monitors 1000_1e, but also wearable electronic devices with display modules such as smart glasses 1000_2a, head-mounted displays 1000_2b, smart watches 1000_2c, as well as automotive electronic devices with display modules 1000_3 such as those placed on car dashboards, center fascia, center information display ("CID"), room mirror displays, and so on.

The heat dissipation layer may be disposed in any region of the electronic device, provided that it is a region with a heat source.

An electronic device in an embodiment of the disclosure may include a heat source and a heat dissipation member including one surface. The heat dissipation member may include the first heat dissipation layer disposed on one surface of the heat source and the second heat dissipation layer disposed on the first heat dissipation layer.

The first heat dissipation layer of the heat dissipation member may include the first heat dissipation sheet, and the second heat dissipation layer of the heat dissipation member may include the second heat dissipation sheet.

Among the heat dissipation members, only the first heat dissipation layer may include a plurality of first heat dissipation sheets. Among the heat dissipation members, only the second heat dissipation layer may include a plurality of second heat dissipation sheets. Each of the first heat dissipation layer and the second heat dissipation layer may include a plurality of first heat dissipation sheets and a plurality of second heat dissipation sheets.

The heat source is not limited as long as it is a location where heat is generated in an electronic device. In an embodiment, the heat source may be a display panel of the display device, for example.

While this disclosure has been described in connection with what is presently considered to be practical embodiments, it should be understood that the disclosure is not limited to the disclosed embodiments, but, on the contrary, is intended to cover various modifications and equivalent arrangements included within the scope of the appended claims.

Embodiments are set out in the following numbered clauses:
Clause 1. A display device comprising: a display panel including a first surface and a second surface opposing to each other; and a heat dissipation member including: a first heat dissipation layer disposed on the second surface of the display panel; and a second heat dissipation layer disposed on the first heat dissipation layer.
Clause 2. The display device of clause 1, wherein the first heat dissipation layer comprises a plurality of first heat dissipation sheets arranged in a first direction or a second direction intersecting the first direction, and the second heat dissipation layer comprises a plurality of second heat dissipation sheets arranged in the first direction or the second direction.
Clause 3. The display device of clause 2, wherein first heat dissipation sheets next to each other among the plurality of first heat dissipation sheets are partitioned by a first boundary line extending in the second direction, and a second heat dissipation sheet of the plurality of second heat dissipation sheets covers the first boundary line.
Clause 4. The display device of clause 3, wherein an edge of a first heat dissipation sheet extending in the first direction among the plurality of first heat dissipation sheets is aligned with an edge of the second heat dissipation sheet extending in the first direction.
Clause 5. The display device of clause 3 or 4, wherein the first heat dissipation layer comprises a plurality of first heat dissipation sheets partitioned by a second boundary line extending in the first direction, and the second heat dissipation layer comprises the second heat dissipation sheet covering the second boundary line.
Clause 6. The display device of any one of clauses 2 to 5, wherein the first heat dissipation layer comprises a plurality of first heat dissipation sheets partitioned into a first boundary line extending in the second direction and a second boundary line extending in the first direction, and the second heat dissipation sheet does not cover the first boundary line or the second boundary line.
Clause 7. The display device of any one of clauses 2 to 6, wherein at least one edge of the first heat dissipation sheet is misaligned with at least one edge of the second heat dissipation sheet.
Clause 8. The display device of any one of clauses 2 to 7, wherein a distance between the first heat dissipation sheets next to each other among the plurality of first heat dissipation sheets is 3 millimeters or less, and a distance between second heat dissipation sheets next to each other among the plurality of second heat dissipation sheets is 3 millimeters or less.
Clause 9. The display device of any one of clauses 2 to 8, wherein the first heat dissipation sheet and the second heat dissipation sheet comprise a vapor chamber.
Clause 10. The display device of any one of clauses 2 to 9, wherein at least one of the first heat dissipation sheet and the second heat dissipation sheet comprises a pulsating heat pipe.
Clause 11. The display device of clause 10, wherein the first heat dissipation sheet comprises a first pipe including a first straight flow path, a first connecting flow path, and a first closed flow path, the second heat dissipation sheet comprises a second pipe including a second straight flow path, a second connecting flow path, and a second closed flow path, and the first pipe and the second pipe are closed-loop pulsating heat pipes.
Clause 12. The display device of clause 11, wherein at least one of cross-sections of the first straight flow path and cross-sections of the second straight flow path comprises a first region, a second region, and a third region having different diameters.
Clause 13. The display device of clause 11 or 12, wherein an extension directions of the first straight flow path and the second straight flow path are parallel to each other.
Clause 14. The display device of clause 11, 12 or 13, wherein the first straight flow path and the second straight flow path intersect each other, the first straight flow path extends in the first direction, and the second straight flow path extends in the second direction.
Clause 15. The display device of any one of clauses 11 to 14, wherein the first straight flow path and the second straight flow path extend in a diagonal direction with respect to the first direction and the second direction.
Clause 16. The display device of any one of clauses 1 to 15, wherein the display panel comprises a substrate; a transistor disposed on the substrate; a pixel electrode electrically connected to the transistor; a light-emitting layer disposed on the pixel electrode; and a common electrode disposed on the light-emitting layer.
Clause 17. A display device, comprising: a display panel including a first surface capable of displaying an image and a second surface opposite to the first surface; and a heat dissipation member including a first heat dissipation layer disposed on the second surface and a second heat dissipation layer disposed on the first heat dissipation layer.
Clause 18. The display device of clause 17, wherein the first heat dissipation layer comprises at least one first heat dissipation sheet arranged in a first direction or a second direction intersecting the first direction, and the second heat dissipation layer comprises at least one second heat dissipation sheet arranged in the first direction or the second direction.
Clause 19. An electronic device comprising: a heat source including one surface; and a heat dissipation member including a first heat dissipation layer disposed on the one surface of the heat source and a second heat dissipation layer disposed on the first heat dissipation layer.
Clause 20. The electronic device of clause 19, wherein each of the first heat dissipation layer and the second heat dissipation layer comprises a first heat dissipation sheet and a second heat dissipation sheet, and at least one of the first heat dissipation layer and the second heat dissipation layer comprises a plurality of first heat dissipation sheets or a plurality of second heat dissipation sheets.

## Claims

1. An electronic device comprising:
a heat source (1) including one surface (S2); and
a heat dissipation member (100) including:
a first heat dissipation layer (110) disposed on the one surface (S2); and
a second heat dissipation layer (120) disposed on the first heat dissipation layer (110).

2. The electronic device of claim 1, wherein the first heat dissipation layer (110) comprises a first heat dissipation sheet (115a) arranged in a first direction (x) or a second direction (y) intersecting the first direction (x), and the second heat dissipation layer (120) comprises a second heat dissipation sheet (125a) arranged in the first direction (x) or the second direction (y), optionally at least one of the first heat dissipation layer (110) and the second heat dissipation layer (120) respectively comprises a plurality of first heat dissipation sheets (115) or a plurality of second heat dissipation sheets (125).

3. The electronic device of claim 2, wherein first heat dissipation sheets (115) next to each other among the plurality of first heat dissipation sheets (115) are partitioned by a first boundary line (BL1) extending in the second direction (y), and
a second heat dissipation sheet (125a) of the plurality of second heat dissipation sheets (125) covers the first boundary line (BL1), optionally wherein an edge of a first heat dissipation (115a) sheet extending in the first direction (x) among the plurality of first heat dissipation sheets (115) is aligned with an edge of the second heat dissipation sheet (125a) extending in the first direction (x).

4. The electronic device of claim 3, wherein the first heat dissipation layer (110) comprises a plurality of first heat dissipation sheets (115) partitioned by a second boundary line (BL2) extending in the first direction (x), and
the second heat dissipation layer (120) comprises the second heat dissipation sheet (125a) covering the second boundary line (BL2).

5. The electronic device of claim 2, wherein the first heat dissipation layer (110) comprises a plurality of first heat dissipation sheets (115) partitioned into a first boundary line (BL1) extending in the second direction (y) and a second boundary line (BL2) extending in the first direction (x), and
the second heat dissipation sheet (125a) does not cover the first boundary line (BL1) or the second boundary line (BL2).

6. The electronic device of any one of claims 2 to 5, wherein at least one edge of the first heat dissipation sheet (115a) is misaligned with at least one edge of the second heat dissipation sheet (125a).

7. The electronic device of any one of claims 2 to 6, wherein a distance between the first heat dissipation sheets (115a) next to each other among the plurality of first heat dissipation sheets (115) is 3 millimeters or less, and a distance between second heat dissipation sheets (125) next to each other among the plurality of second heat dissipation sheets (125) is 3 millimeters or less.

8. The electronic device of any one of claims 2 to 7, wherein the first heat dissipation sheet (115a) and the second heat dissipation sheet (125a) comprise a vapor chamber (VC).

9. The electronic device of any one of claims 2 to 8, wherein at least one of the first heat dissipation sheet (115a) and the second heat dissipation sheet (125a) comprises a pulsating heat pipe (PHP).

10. The electronic device of claim 9, wherein the first heat dissipation sheet (115a) comprises a first pipe (210a) including a first straight flow path (211a), a first connecting flow path (212a), and a first closed flow path (213a), the second heat dissipation sheet (125a) comprises a second pipe (220a) including a second straight flow path (221a), a second connecting flow path (222a), and a second closed flow path (223a), and the first pipe (210a) and the second pipe (220a) are closed-loop pulsating heat pipes.

11. The display device of claim 10, wherein at least one of cross-sections of the first straight flow path (211a) and cross-sections of the second straight flow path (221a) comprises a first region, a second region, and a third region having different diameters, optionally wherein an extension direction of each of the first straight flow path (211a) and the second straight flow path (221a) are parallel to each other.

12. The electronic device of claim 10 or 11, wherein the first straight flow path (211a) and the second straight flow path (221a) intersect each other, optionally the first straight flow path (211a) extends in the first direction (x), and the second straight flow path (221a) extends in the second direction (y).

13. The electronic device of claim 10, 11 or 12, wherein the first straight flow path (211a) and the second straight flow path (221a) extend in a diagonal direction with respect to the first direction (x) and the second direction (y).

14. The electronic device as claimed in any one of claims 1 to 13, wherein the heat source includes a display panel (1) having a opposite surface (S1) opposite the one surface (S2), the opposite surface (S1) being capable of displaying an image.

15. The electronic device of claim 14, wherein the display panel (DP) comprises:
a substrate (SUB);
a transistor (TR) disposed on the substrate (SUB);
a pixel electrode (E1) electrically connected to the transistor (TR);
a light-emitting layer (EL) disposed on the pixel electrode (E1); and
a common electrode (E2) disposed on the light-emitting layer (EL).
